# FASCICULE DE BREVET EUROPEEN

(11) **EP 4 376 077 B1**
(45) Date de publication et mention de la délivrance du brevet: **12.02.2025**
(21) Numéro de dépôt: 23209592.7
(22) Date de dépôt: 14.11.2023
(51) Int. Cl.: H01L 25/075, H01L 25/16

(54) **DISPOSITIF D'AFFICHAGE**
ANZEIGEVORRICHTUNG
DISPLAY DEVICE

(30) Priorité: 18.11.2022 FR 2212008
(43) Date de publication de la demande: 29.05.2024
(73) Titulaire: Commissariat à l'Energie Atomique et aux Energies Alternatives, 75015 Paris (FR)
(72) Inventeur: TEMPLIER, François, 38054 Grenoble Cedex 09 (FR); BECKER, Sébastien, 38054 Grenoble Cedex 09 (FR); BOURVON, Hélène, 38054 Grenoble Cedex 09 (FR)
(74) Mandataire: Cabinet Beaumont

(56) Documents cités:
- EP-A1- 3 401 958
- EP-A1- 3 958 309
- US-A1- 2021 265 323

## Description

### Domaine technique

La présente description concerne de façon générale le domaine des dispositifs d'affichage d'images, et vise plus particulièrement un dispositif d'affichage d'images interactif, combinant une fonction d'émission lumineuse et une fonction de capture optique, et un procédé de fabrication d'un tel dispositif.

### Technique antérieure

Il a déjà été proposé, par exemple dans les demandes de brevet WO2017089676, EP3401958 et WO2018185433 précédemment déposées par le demandeur, des dispositifs d'affichage d'images comportant une pluralité de puces ou micropuces électroniques monolithiques élémentaires disposées en matrice sur un même substrat de report. Les puces élémentaires sont montées solidaires du substrat de report et connectées à des éléments de connexion électrique du substrat de report pour leur commande. Chaque puce comporte une ou plusieurs diodes électroluminescentes (LED) et un circuit intégré de commande de ladite une ou plusieurs LED, et correspond à un pixel du dispositif. Le circuit intégré de commande comprend une face de connexion opposée à ladite une ou plusieurs LED, comprenant une pluralité de plages de connexion électrique destinées à être connectées au substrat de report pour la commande de la micropuce. Le substrat de report comprend une face de connexion comportant, pour chaque micropuce, une pluralité de plages de connexion électrique destinées à être connectées respectivement aux plages de connexion électrique de la micropuce. Les puces sont rapportées sur le substrat de report, faces de connexion tournées vers la face de connexion du substrat de report, et fixées sur le substrat de report de façon à connecter les plages de connexion électrique de chaque micropuce aux plages de connexion électrique correspondantes du substrat de report.

Ce type de dispositif d'affichage est particulièrement adapté pour réaliser des écrans d'affichage de grande surface, par exemple des écrans d'ordinateur, de téléviseur, de tablette, etc.

On s'intéresse ici plus particulièrement à la réalisation d'un dispositif d'affichage d'images interactif combinant une fonction d'émission lumineuse et une fonction de capture optique. Plus particulièrement, on s'intéresse ici à la réalisation d'un dispositif d'affichage d'images interactif combinant une fonction d'émission de lumière visible pour afficher des images, et une fonction d'émission-réception de lumière, par exemple infrarouge, pour des applications de détection. Les documents EP 3 958 309 A1 et US 2021/265323 A1 décrivent des dispositifs d'affichage d'images interactifs comprenant des LEDs et des diodes laser.

### Résumé de l'invention

Un mode de réalisation prévoit un dispositif comportant :
- un substrat de report comportant des éléments de connexion électrique ;
- une pluralité de premières puces élémentaires monolithiques fixées et connectées électriquement au substrat de report, chaque première puce élémentaire comportant au moins une LED et un circuit électronique intégré de commande de ladite au moins une LED,
le dispositif comportant en outre, associé à au moins une des premières puces élémentaires, une deuxième puce élémentaire comprenant une diode laser à cavité verticale émettant par la surface, fixée et connectée électriquement au substrat de report, la première puce élémentaire comportant un circuit électronique intégré de commande de ladite diode laser.

Selon un mode de réalisation, le dispositif comprend en outre une pluralité de détecteurs photosensibles, et, associé à chaque détecteur photosensible, un circuit électronique intégré de lecture du détecteur photosensible connecté électriquement au substrat de report.

Selon un mode de réalisation, chaque détecteur photosensible est associé à une première puce élémentaire, le circuit électronique de lecture du détecteur photosensible étant intégré à ladite première puce élémentaire.

Selon un mode de réalisation, chaque photodétecteur comprend une couche organique photosensible.

Selon un mode de réalisation, chaque photodétecteur comprend une photodiode inorganique, par exemple à base de matériaux semiconducteurs de type III-V, par exemple à base d'arséniure d'indium-gallium, ou à base de silicium amorphe.

Selon un mode de réalisation, chaque photodétecteur comprend une couche matrice, par exemple en résine, dans laquelle sont incorporées des boîtes quantiques.

Selon un mode de réalisation, chaque photodétecteur comprend une photodiode en silicium en technologie CMOS, une photodiode à avalanche, ou un dispositif de détection permettant d'acquérir une information quant à la distance entre le dispositif et la scène observée par mesure directe ou indirecte du temps de vol de la lumière.

Selon un mode de réalisation, la diode laser est adaptée à émettre dans une gamme de longueurs d'ondes de sensibilité des photodétecteurs, par exemple dans l'infrarouge.

Selon un mode de réalisation, dans chaque première puce élémentaire, le circuit électronique de commande de ladite au moins une LED et le circuit électronique de commande de la diode laser comprennent des transistors MOS formés dans et sur une couche de silicium monocristallin.

Selon un mode de réalisation, dans chaque première puce élémentaire, ladite au moins une LED est une LED inorganique, par exemple au nitrure de gallium.

Selon un mode de réalisation, dans chaque première puce élémentaire, ladite au moins une LED est adaptée à émettre de la lumière visible.

Selon un mode de réalisation, chaque première puce élémentaire comporte un circuit électronique intégré adapté à commander une diode laser d'une deuxième puce élémentaire, et le nombre de deuxièmes puces élémentaires est inférieur au nombre de premières puces élémentaires, de sorte que certaines premières puces élémentaires ont leur circuit de commande de diode laser non connecté à une diode laser.

Selon un mode de réalisation, la deuxième puce élémentaire comprend deux plages métalliques de connexion reliées respectivement à une région d'anode et à une région de cathode de la diode laser, lesdites deux plages métalliques de connexion étant connectées à respectivement deux plages métalliques de connexion de la première puce élémentaire par l'intermédiaire d'éléments conducteurs d'interconnexion du substrat de report.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C, la figure 1D, la figure 1E, la figure 1F, la figure 1G, la figure 1H, la figure 1I et la figure 1J sont des vues en coupe illustrant des étapes successives d'un exemple d'un procédé de fabrication de puces élémentaires de pixel d'un dispositif d'affichage interactif selon un mode de réalisation ;
la figure 2 est une vue de dessus illustrant de façon schématique et partielle un exemple d'un substrat de report d'un dispositif d'affichage interactif selon un mode de réalisation ;
la figure 3A, la figure 3B et la figure 3C sont des vues en coupe illustrant des étapes successives d'un exemple d'un procédé de fabrication d'un dispositif d'affichage interactif selon un mode de réalisation ; et
la figure 4 est une vue de dessus schématique d'un exemple d'un dispositif d'affichage interactif selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les diverses applications que peuvent avoir les dispositifs d'affichage interactifs décrits n'ont pas été détaillées, les modes de réalisation décrits étant compatibles avec toutes ou la plupart des applications connues d'un dispositif d'affichage émissif intégrant une fonction d'émission-réception lumineuse, par exemple des applications de détection de mouvement, de reconnaissance de visage, d'identification, etc.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Selon un aspect d'un mode de réalisation, on prévoit un dispositif d'affichage d'images comportant une pluralité de puces électroniques monolithiques élémentaires disposées en matrice sur un même substrat de report. Comme dans les exemples décrits dans les demandes de brevet WO2017089676, EP3401958 et WO2018185433 précédemment déposées par le demandeur, les puces élémentaires sont montées solidaires du substrat de report et connectées à des éléments de connexion électrique du substrat de report. Chaque puce comporte une ou plusieurs LED et un circuit de commande de ladite une ou plusieurs LED et correspond à un pixel du dispositif d'affichage. Le circuit de commande comprend une face de connexion opposée à ladite une ou plusieurs LED, comprenant une pluralité de plages (aussi appelées bornes ou plots) de connexion électrique destinées à être connectées au substrat de report pour la commande de la micropuce. Le substrat de report comprend une face de connexion comportant, pour chaque micropuce, une pluralité de plages (aussi appelées bornes ou plots) de connexion électrique destinées à être connectées respectivement aux plages de connexion électrique de la micropuce. Les puces sont rapportées sur le substrat de report, faces de connexion tournées vers la face de connexion du substrat de report, et fixées sur le substrat de report de façon à connecter les plages de connexion électrique de chaque micropuce aux plages de connexion électrique correspondantes du substrat de report.

Selon un aspect d'un mode de réalisation, le dispositif d'affichage d'images comprend en outre une fonction d'émission-réception d'un rayonnement lumineux, par exemple infrarouge, permettant de détecter des éléments ou des variations de l'environnement du dispositif.

Pour cela, le dispositif comprend une pluralité de détecteurs photosensibles, par exemple des photodétecteurs organiques, par exemple agencés en matrice selon des rangées et des colonnes, définissant un capteur d'images.

Le dispositif d'affichage comprend en outre une ou plusieurs diodes laser à cavité verticale émettant par la surface, aussi appelées VCSEL (de l'anglais « Vertical-cavity surface-emitting laser », adaptées à émettre dans une gamme de longueur d'onde de sensibilité des détecteurs photosensibles.

Les VCSEL sont par exemple externes aux puces élémentaires de pixels du dispositif d'affichage, et sont disposés sur le substrat de report du dispositif, du même côté du substrat de report que les puces élémentaires de pixel. Les VCSEL sont par exemple connectées à des bornes de connexion électrique du substrat de report pour leur commande.

A titre d'exemple, le dispositif comprend une diode VCSEL par puce élémentaire de pixel du dispositif, disposée au voisinage de ladite puce élémentaire de pixel. Autrement dit, la matrice de puces élémentaires de pixel du dispositif d'affichage et la matrice de diodes VCSEL sont des matrices entrelacées de mêmes dimensions et de même pas.

Les photodétecteurs sont par exemple eux aussi externes aux puces élémentaires de pixel du dispositif d'affichage, et sont disposés sur le substrat de report du dispositif, du même côté du substrat de report que les puces élémentaires de pixel. Les photodétecteurs sont par exemple connectés à des bornes de connexion électrique du substrat de report pour leur lecture.

A titre d'exemple, le dispositif comprend un photodétecteur par puce élémentaire de pixel du dispositif, disposé au voisinage de ladite puce élémentaire de pixel. Autrement dit, la matrice de puces élémentaires de pixel du dispositif d'affichage et la matrice de photodétecteurs sont des matrices entrelacées de mêmes dimensions et de même pas.

Selon un aspect d'un mode de réalisation, chaque puce élémentaire de pixel du dispositif d'affichage intègre un circuit électronique de commande de la diode VCSEL correspondante, c'est-à-dire de même position dans la matrice de pixels, du dispositif. Chaque puce élémentaire de pixel du dispositif comprend pour cela deux bornes de connexion reliées, par exemple connectées, respectivement aux deux électrodes de la diode VCSEL par l'intermédiaire de pistes conductrices du substrat de report.

Chaque puce élémentaire de pixel du dispositif d'affichage peut en outre intégrer un circuit électronique de lecture d'un signal électrique représentatif d'une intensité lumineuse reçue par le photodétecteur correspondant, c'est-à-dire de même position dans la matrice de pixels, du dispositif. Dans ce cas, chaque puce élémentaire de pixel du dispositif comprend pour cela une borne de connexion connectée individuellement à une électrode du photodétecteur associé par l'intermédiaire d'une piste conductrice du substrat de report.

Des exemples de réalisation d'un tel dispositif d'affichage interactif vont être décrits plus en détail ci-après en relation avec les figures.

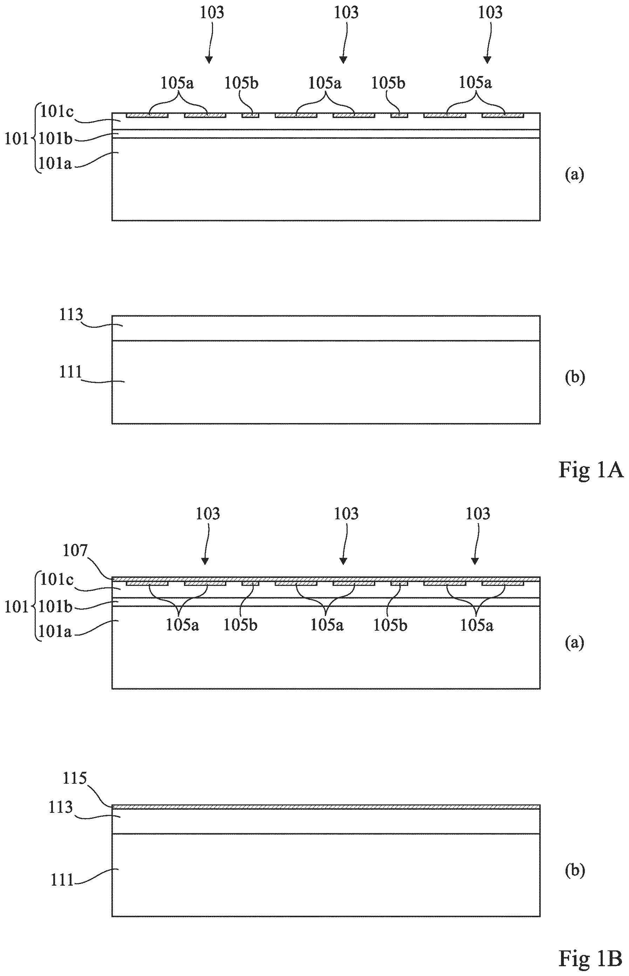

Les figures 1A à 1J sont des vues en coupe illustrant un exemple d'un procédé de fabrication des puces élémentaires de pixel du dispositif.

La figure 1A comprend une vue (a) représentant de façon schématique une structure de contrôle comprenant un premier substrat 101 dans et sur lequel ont été formés une pluralité de circuits intégrés élémentaires de contrôle 103, par exemple identiques ou similaires, correspondant respectivement aux circuits intégrés de contrôle des futures puces élémentaires de pixel du dispositif.

Dans l'exemple représenté, le substrat 101 est un substrat de type SOI (de l'anglais "Semiconductor On Insulator" - semiconducteur sur isolant), comportant un substrat semiconducteur de support 101a, par exemple en silicium, une couche isolante 101b, par exemple en oxyde de silicium, disposée sur et en contact avec la face supérieure du substrat de support 101a, et une couche semiconductrice supérieure 101c, par exemple en silicium monocristallin, disposée sur et en contact avec la face supérieure de la couche isolante 101b.

Dans cet exemple, les circuits élémentaires de contrôle 103 sont formés dans et sur la couche semiconductrice supérieure 101c du substrat 101. Chaque circuit élémentaire de contrôle 103 comprend par exemple une pluralité de transistors MOS (non détaillés sur les figures 1A à 1I). Les circuits élémentaires de contrôle 103 sont par exemple réalisés en technologie CMOS (de l'anglais "Complementary Metal Oxide Semiconductor" - métal oxyde semiconducteur complémentaire). Chaque circuit élémentaire de contrôle 103 peut comprendre un circuit adapté à contrôler l'émission de lumière par la ou les LED de la future puce élémentaire de pixel du dispositif, et un circuit de commande adapté à contrôler l'émission de lumière par la diode VCSEL associée à la future puce élémentaire de pixel du dispositif. Chaque circuit élémentaire de contrôle 103 peut en outre comprendre un circuit de lecture du photodétecteur associé à la future puce élémentaire de pixel du dispositif.

Dans cet exemple, chaque circuit élémentaire de contrôle 103 comprend, du côté de sa face supérieure, un ou plusieurs plots de connexion métalliques 105a, 105b. A titre d'exemple, les plots 105a, 105b affleurent du côté de la face supérieure d'une couche isolante supérieure, par exemple en oxyde de silicium, d'un empilement d'interconnexion (non détaillé sur les figures) revêtant la face supérieure de la couche semiconductrice supérieure 103c du substrat 101. Ainsi, dans cet exemple, la surface supérieure de la structure de contrôle de la vue (a) est une surface plane comportant une alternance de régions métalliques (les plots 105a, 105b) et de régions isolantes.

A titre d'exemple, chaque circuit élémentaire de contrôle 103 comprend un plot métallique 105a spécifique pour chaque LED de la future puce élémentaire de pixel du dispositif, destiné à être connecté à une région d'anode de la LED et permettant de commander individuellement l'émission de lumière par ladite LED. Chaque circuit élémentaire de contrôle 103 peut en outre comprendre un plot métallique 105b destiné à être connecté à une région de cathode de chaque LED de la future puce élémentaire de pixel du dispositif. Dans le cas où la puce élémentaire comporte plusieurs LED, le contact de cathode peut être commun à toutes les LED de la puce. Ainsi, le circuit élémentaire de contrôle 103 peut comprendre un unique plot métallique 105b.

A titre d'exemple, chaque puce élémentaire de pixel du dispositif comprend trois LED commandables individuellement adaptées à émettre respectivement de la lumière bleue, de la lumière verte et de la lumière rouge. Dans ce cas, chaque circuit élémentaire de contrôle 103 peut comprendre trois plots métalliques 105a distincts destinés à être connectés respectivement aux régions d'anode des trois LED, et un unique plot métallique 105b destiné à être connecté collectivement aux régions de cathode des trois LED. Sur la figure 1A, seuls deux plots métalliques 105a et un plot métallique 105b par circuit électronique ont été représentés.

La figure 1A comprend en outre une vue (b) représentant de façon très schématique une structure comprenant un deuxième substrat 111, sur la face supérieure duquel repose un empilement actif de LED 113. L'empilement actif de LED 113 est par exemple un empilement de LED inorganique, par exemple à base d'un ou plusieurs matériaux semiconducteurs de type III-V, par exemple à base de nitrure de gallium. Le substrat 111 est par exemple en saphir ou en silicium.

L'empilement actif de LED 113 comprend par exemple, dans l'ordre en partant de la face supérieure du substrat 111, une couche semiconductrice dopée de type N formant une couche de cathode, une couche active, et une couche semiconductrice dopée de type P formant une couche d'anode (couches non détaillées sur la figure). La couche active comporte par exemple une alternance de couches de puits quantiques en un premier matériau semiconducteur et de couches barrières en un deuxième matériau semiconducteur définissant un empilement de puits quantiques multiples.

L'empilement actif 113 peut être formé par épitaxie sur la face supérieure du substrat 111. A titre de variante, l'empilement actif 113 est formé par épitaxie sur un substrat de croissance, non représenté, puis reporté sur la face supérieure du substrat 111.

A ce stade, l'empilement 113 n'est pas encore structuré en LED individuelles. Autrement dit, les couches de l'empilement 113 s'étendent chacune de façon continue et avec une épaisseur sensiblement uniforme sur toute la surface supérieure du substrat 111.

La figure 1B comprend une vue (a) illustrant une étape de dépôt d'une couche métallique 107 sur et en contact avec la face supérieure de la structure de contrôle de la vue (a) de la figure 1A. Dans cet exemple, la couche 107 s'étend de façon continue et avec une épaisseur sensiblement uniforme sur toute la surface supérieure de l'empilement d'interconnexion de la structure de contrôle de la vue (a) de la figure 1A. Ainsi, la couche 107 connecte les uns aux autres tous les plots métalliques 105a, 105b de la structure de contrôle.

La figure 1B comprend en outre une vue (b) illustrant une étape de dépôt d'une couche métallique 115 sur et en contact avec la face supérieure de l'empilement actif de LED 113 de la structure de la vue (b) de la figure 1A. La couche métallique 115 peut être une couche unique ou un empilement de plusieurs couches métalliques. De préférence, la couche métallique 115 comprend, du côté de sa face supérieure, une couche en le même matériau que la couche 107.

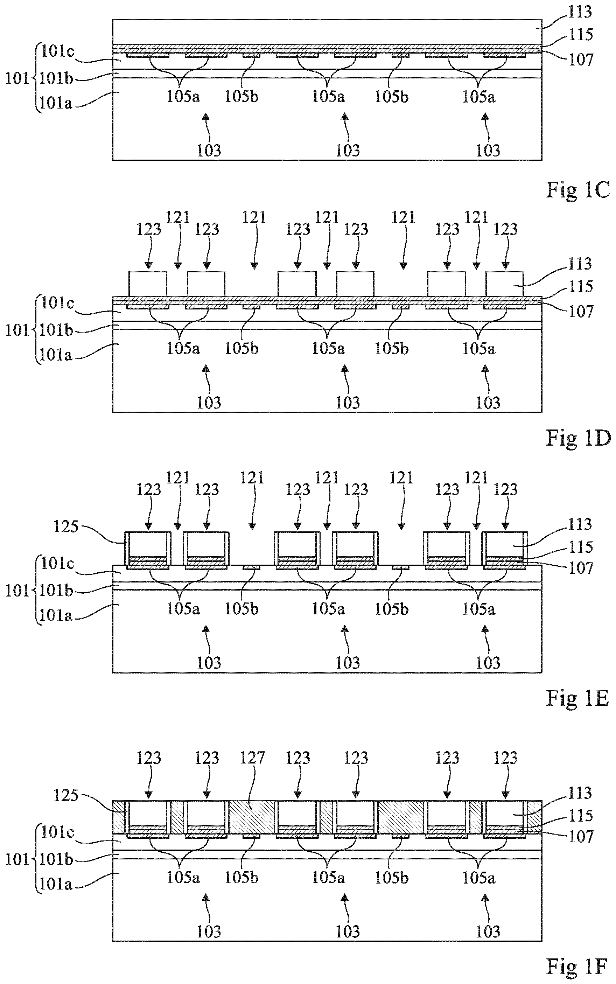

La figure 1C illustre la structure obtenue à l'issue d'une étape de report et de fixation de l'empilement actif de LED 113 et de la couche métallique 115 sur la structure de la vue (a) de la figure 1B.

Sur la figure 1C, l'orientation de la structure de la vue (a) de la figure 1B reste inchangée. En revanche, les éléments de la structure de vue (b) de la figure 1B sont inversés par rapport à l'orientation de la figure 1B.

Lors de cette étape, la structure de la vue (b) de la figure 1B est rapportée sur la face supérieure de la structure de la vue (a) de la figure 1B, en utilisant le substrat 111 comme poignée. La face inférieure (dans l'orientation de la figure 1C, correspondant à la face supérieure dans l'orientation de la figure 1B) de la couche métallique 115 est fixée sur la face supérieure de la couche métallique 107. La fixation est par exemple obtenue par collage direct ou collage moléculaire de la face inférieure de la couche 115 sur la face supérieure de la couche 107, c'est-à-dire sans apport de matière entre les deux couches.

Le substrat 111 est ensuite retiré, par exemple par meulage et/ou gravure chimique, de façon à libérer l'accès à la face supérieure de l'empilement actif de LED 113, c'est-à-dire, dans cet exemple, la face supérieure de la couche semiconductrice de cathode de l'empilement actif de LED 113.

La figure 1D illustre une étape de formation de tranchées 121 s'étendant verticalement dans l'empilement actif de LED depuis sa face supérieure et délimitant latéralement, dans l'empilement 113, une pluralité d'ilots 123 correspondant aux LED individuelles des futures puces élémentaires du dispositif. Les tranchées 121 sont par exemple formées par gravure plasma. Dans l'exemple de la figure 1D, les tranchées 121 s'interrompent sur la face supérieure de la couche métallique 115. En vue de dessus (non représentée), les tranchées 121 forment une grille séparant latéralement les diodes élémentaires 123 les unes des autres.

La figure 1E illustre une étape ultérieure de prolongement vertical des tranchées 121 à travers les couches métalliques 107 et 115, par exemple en utilisant le même masque de gravure (non représenté) que celui utilisé à l'étape précédente. A l'issue de cette étape, les tranchées 121 débouchent sur la face supérieure de l'empilement d'interconnexion revêtant la face supérieure du substrat 101.

La portion de l'empilement des couches 107 et 115 subsistant sous chaque LED 123 à l'issue de cette étape constitue une électrode d'anode de la LED. Ladite électrode d'anode est en contact, par sa face inférieure, avec la face supérieure d'un plot métallique de connexion 105a du circuit élémentaire de contrôle 103 sous-jacent. Ainsi, chaque LED a son électrode d'anode connectée individuellement à un plot métallique de connexion 105a d'un circuit élémentaire de contrôle 103.

Dans cet exemple, une tranchée 121 est en outre formée en vis-à-vis de chaque plot métallique de connexion 105b de façon à libérer l'accès à la face supérieure des plots 105b.

La figure 1E illustre en outre une étape ultérieure de passivation des flancs des LED 123. Pour cela, une couche 125 en un matériau électriquement isolant, par exemple de l'oxyde de silicium ou du nitrure de silicium, est déposée par une méthode de dépôt conforme sur la face supérieure de la structure. La couche 125 revêt alors la face supérieure et les flancs des LED 123, ainsi que les flancs des portions des couches métalliques 107 et 115 situées sous les LED 123, et, au fond des tranchées 121, la face supérieure de l'empilement d'interconnexion revêtant le substrat 101. Une étape de gravure anisotrope verticale est ensuite mise en oeuvre pour retirer les portions horizontales de la couche 125, et conserver uniquement les portions verticales de cette couche, revêtant les flancs des LED 123 et les flancs des portions des couches métalliques 107 et 115 situées sous les LED 123.

La figure 1F illustre une étape ultérieure de remplissage des tranchées 121 par du métal 127. A titre d'exemple, le métal 127 est initialement déposé sur toute la surface supérieure de la structure avec une épaisseur supérieure à la profondeur des tranchées 121, de façon à combler entièrement les tranchées 121. Une étape de planarisation, par exemple par polissage mécano-chimique, est ensuite mise en oeuvre pour libérer l'accès à la face supérieure des LED 123. On obtient ainsi une surface supérieure sensiblement plane sur laquelle affleurent les régions semiconductrices de cathode des LED 123, les régions verticales d'isolation 125 des LED, et les régions métalliques 127 remplissant les tranchées 121. En vue de dessus (non représentée), les régions métalliques 127 forment une grille conductrice séparant latéralement les LED 123 les unes des autres. Les régions métalliques 127 sont connectées électriquement aux plots métalliques 105b au fond des tranchées 121, et définissent une métallisation de contact de cathode commune à l'ensemble des LED 123 de la structure.

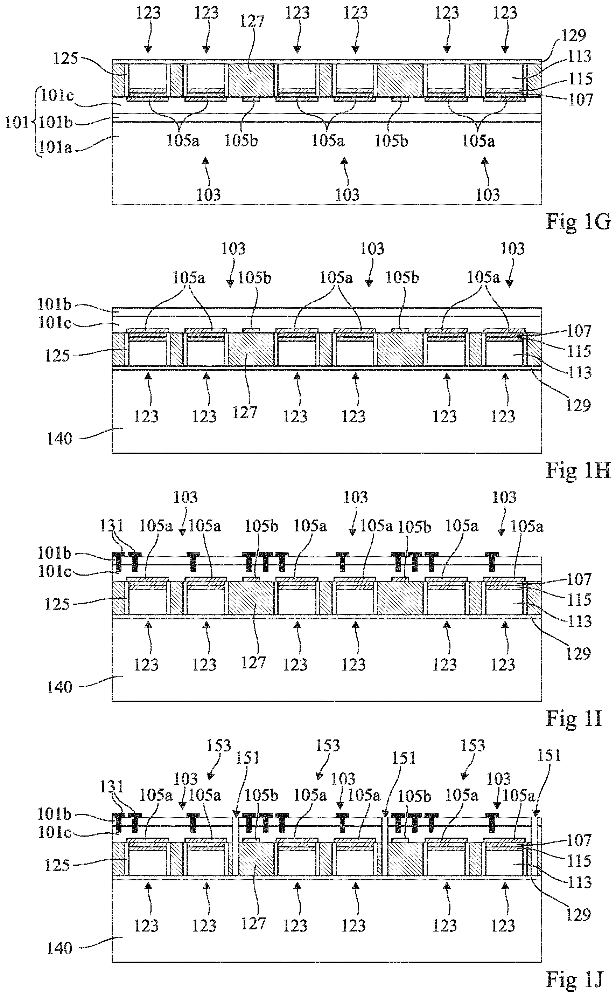

La figure 1G illustre une étape ultérieure de dépôt d'une couche conductrice 129, transparente aux longueurs d'onde d'émission des LED du dispositif d'affichage, sur la face supérieure de la structure. La couche 129 s'étend par exemple de façon continue et avec une épaisseur sensiblement uniforme sur toute la surface supérieure de la structure de la figure 1F. La couche 129 est par exemple en un oxyde conducteur transparent, par exemple en oxyde d'indium-étain (ITO). A titre de variante, la couche 129 peut être une couche métallique suffisamment mince pour être transparente, par exemple une couche d'argent d'épaisseur inférieure à 80 nm.

La couche 129 est en contact, par sa face inférieure, avec la face supérieure des régions semiconductrices de cathode des LED 123, et définit une électrode commune de cathode des LED 123. La couche 129 est en outre en contact, par sa face inférieure, avec la face supérieure de la région métallique 127. Ainsi, la couche 129 connecte électriquement la région semiconductrice de cathode de chaque LED 123 à la métallisation de contact de cathode commune 127 de la structure.

La figure 1H illustre une étape ultérieure de report de la structure de la figure 1G sur un substrat de support temporaire 140. Sur la figure 1H, l'orientation de la structure est inversée par rapport à l'orientation de la figure 1G. Le substrat de support temporaire est fixé sur la face de la couche conductrice 129 opposée au substrat 101, c'est-à-dire sa face inférieure dans l'orientation de la figure 1H (correspondant à sa face supérieure dans l'orientation de la figure 1G). Le substrat de support temporaire 140 est par exemple un substrat en silicium. La fixation du substrat de support temporaire 140 sur la couche conductrice 129 peut être obtenue au moyen d'une couche adhésive de collage, ou par collage direct.

La figure 1H illustre en outre une étape ultérieure de retrait du substrat de support 101a de la structure SOI de départ, par exemple par meulage et/ou gravure chimique, de façon à libérer l'accès à la face supérieure de la couche isolante 101b de la structure SOI.

On notera que les modes de réalisation décrits ne se limitent pas à l'exemple décrit ci-dessus dans lequel le substrat 101 est un substrat de type SOI. A titre de variante, le substrat 101 peut être un substrat semiconducteur massif, par exemple en silicium. Dans ce cas, à l'étape de la figure 1A, le substrat 101 peut être aminci par sa face arrière (face supérieure dans l'orientation de la figure 1H), par exemple par meulage. Une couche isolante de passivation, par exemple en oxyde de silicium, peut ensuite être déposée sur la face supérieure du substrat aminci, remplaçant la couche 101b du substrat SOI. A titre de variante, la couche 101b peut être omise.

La figure 1I illustre la structure obtenue à l'issue d'étapes de formation d'ouvertures de reprise de contact dans les couches 101b et 101c, et de formation de métallisations de reprise de contact 131 dans et sur lesdites ouvertures. Les métallisations de contact 131 permettent de reprendre des contacts électriques sur des niveaux métalliques (non détaillés sur les figures) de l'empilement d'interconnexion disposé du côté de la face inférieure de la couche semiconductrice 101c. Les métallisations 131 sont par exemple connectées électriquement à des transistors du circuit de contrôle, ces transistors étant eux-mêmes connectés ou reliés électriquement à des métallisations de connexion 105a, 105b des LED.

Les métallisations 131 forment des bornes de connexion des futures puces élémentaires de pixel du dispositif, destinées à être connectées à des bornes de connexion correspondantes du substrat de report du dispositif.

La figure 1J illustre la structure obtenue à l'issue d'une étape de singularisation des puces élémentaires de pixel du dispositif. Pour cela, des tranchées 151 s'étendant verticalement à travers les couches 101b, 101c, 127 et 129 sont formées à partir de la face supérieure de la structure, selon des lignes de découpe. Dans cet exemple, les tranchées débouchent sur la face supérieure du substrat de support temporaire 140. En vue de dessus, les tranchées 151 forment une grille continue délimitant latéralement une pluralité de puces élémentaires de pixel 153, par exemple identiques ou similaires, comportant chacune un circuit de contrôle élémentaire 103 et une ou plusieurs LED 123. Les tranchées 151 sont par exemple réalisées par gravure plasma.

On notera que dans l'exemple décrit en relation avec les figures 1A à 1J, les LED élémentaires 123 sont formées à partir d'un même empilement actif de LED et émettent toutes à la même longueur d'onde. Dans le cas où les puces élémentaires 153 comprennent chacune plusieurs LED 123, des étapes de formation d'éléments de conversion lumineuse différentiés sur les différentes LED 123 de chaque puce peuvent être prévues, par exemple après le dépôt de la couche conductrice de cathode 129 et avant la fixation du substrat de support temporaire 140. Par souci de simplification, la réalisation des éléments de conversion n'a pas été détaillée sur les figures. La réalisation de ces éléments est à la portée de la personne du métier à la lecture de la présente description. A titre de variante, chaque puce élémentaire peut comprendre des LED 123 de natures distinctes adaptées à émettre respectivement dans des gammes de longueurs d'ondes distinctes, auquel cas les éléments de conversion peuvent être omis.

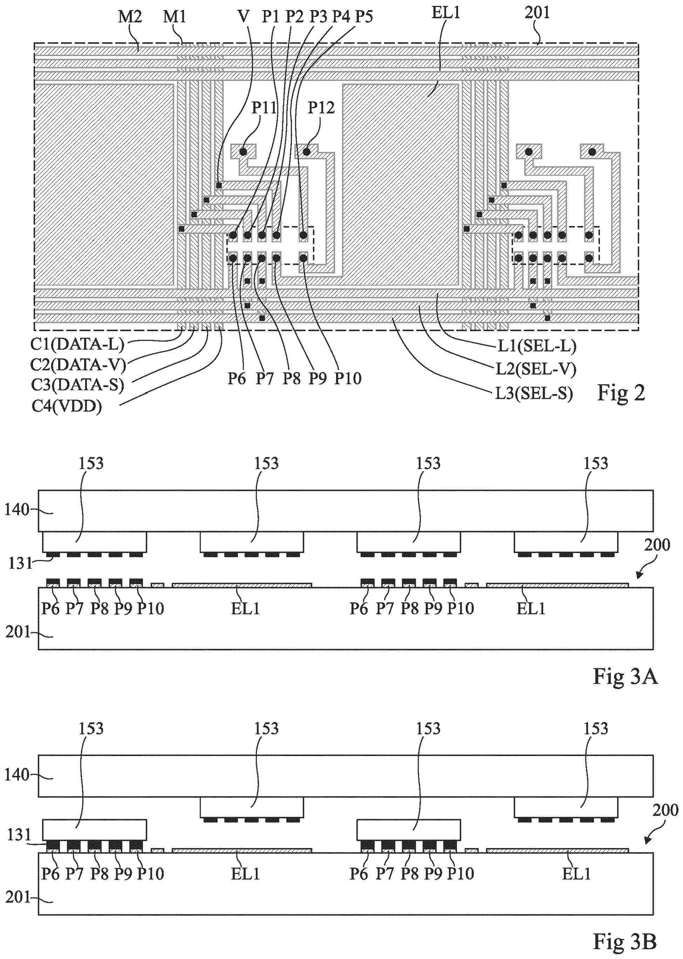

Les puces élémentaires de pixel 153 sont destinées à être reportées sur un substrat de report 200 du dispositif d'affichage, comme cela sera décrit plus en détail ci-après en relation avec les figures 3A à 3C.

La figure 2 est une vue de dessus schématique et partielle d'un exemple de réalisation du substrat de report 200 du dispositif d'affichage.

Le substrat de report 200 comprend par exemple une plaque ou feuille de support 201 en un matériau isolant, par exemple en verre ou en plastique. A titre de variante, la plaque ou feuille de support 201 comprend un support conducteur, par exemple métallique, recouvert par une couche d'un matériau isolant. Le substrat de report comprend en outre des éléments de connexion électrique, et en particulier des pistes conductrices et des plages conductrices, formés sur la face supérieure de la plaque de support 201. Ces éléments de connexion électrique sont par exemple formés par impression d'une succession de niveaux conducteurs et isolants sur la face supérieure de la plaque de support 201. Les éléments de connexion électrique sont par exemple formés par un procédé de dépôt ou d'impression de type impression jet d'encre, par sérigraphie, par rotogravure, par dépôt sous vide, ou par toute autre méthode adaptée.

Dans l'exemple représenté, le substrat de report 200 comprend deux niveaux métalliques conducteurs M1 et M2 séparés par un niveau isolant (non visible sur la figure), et des vias métalliques V connectant les deux niveaux métalliques à travers le niveau isolant. Dans cet exemple, le substrat de report 200 comprend en outre des plages métalliques de connexion formées sur le niveau métallique supérieur M2, destinées à être connectées à des plages de connexion 131 correspondantes des puces élémentaires de pixel 153 du dispositif.

Des circuits actifs de commande du dispositif d'affichage (non représentés), adaptés à alimenter et commander les puces élémentaires du dispositif par l'intermédiaire des éléments de connexion électrique du substrat de report, sont par exemple connectés aux éléments de connexion électrique du substrat de report à la périphérie du substrat de report 200.

Dans l'exemple représenté, la fabrication du substrat de report comprend les trois étapes successives de dépôt suivantes.

Lors d'une première étape de dépôt, on forme sur la face supérieure de la plaque de support 201 une pluralité de pistes conductrices sensiblement parallèles à la direction des colonnes du dispositif d'affichage (direction verticale dans l'orientation de la figure 2). Plus particulièrement, dans cet exemple, lors de la première étape de dépôt, on forme, pour chaque colonne du dispositif d'affichage, quatre pistes conductrices C1, C2, C3 et C4 s'étendant sur sensiblement toute la longueur des colonnes du dispositif d'affichage. Les pistes C1 sont destinées à véhiculer un signal DATA-L de réglage de l'intensité lumineuse émise par les LED 123 des puces élémentaires 153 de la colonne. On notera que dans cet exemple - non limitatif - les signaux de réglage d'intensité des différentes couleurs (rouge, vert, bleu) sont transmis séquentiellement via la piste C1. A titre de variante, non représentée, plusieurs pistes distinctes peuvent être prévues pour transmettre en parallèle, sur des bornes distinctes de chaque puce élémentaire, les signaux de réglage d'intensité des différentes couleurs. Les pistes C2 sont destinées à véhiculer un signal DATA-V de réglage de l'intensité lumineuse émise par les diodes VCSEL des pixels de la colonne. Les pistes C3 sont destinées à véhiculer un signal DATA-S représentatif de l'intensité lumineuse reçue par les photodétecteurs des pixels de la colonne. Les pistes C4 sont destinées à distribuer un potentiel d'alimentation haut VDD aux différentes puces élémentaires de pixel 153.

Les éléments conducteurs formés lors de cette première étape de dépôt définissent le premier niveau conducteur M1 du substrat de report.

Lors d'une deuxième étape de dépôt, on recouvre le premier niveau conducteur d'un matériau isolant (non visible sur la figure), de façon à permettre le dépôt ultérieur de pistes conductrices s'étendant au-dessus des pistes C1, C2, C3 et C4, sans créer de court-circuit avec les pistes C1, C2, C3 et C4.

Lors d'une troisième étape de dépôt, on forme sur la face supérieure de la plaque de support 201 une pluralité de pistes conductrices sensiblement parallèles à la direction des lignes du dispositif d'affichage. Plus particulièrement, dans cet exemple, lors de la troisième étape de dépôt, on imprime, pour chaque ligne du dispositif d'affichage, trois pistes conductrices L1, L2 et L3 s'étendant sur sensiblement toute la longueur des lignes du dispositif d'affichage. Les pistes L1 sont destinées à véhiculer un signal SEL-L de sélection de la ligne de pixels correspondante. Les pistes L2 sont destinées à véhiculer un signal SEL-V de sélection de la ligne de diodes VCSEL correspondante. Les pistes L3 sont destinées à véhiculer un signal SEL-S de sélection de la ligne de photodétecteurs correspondante.

Dans cet exemple, lors de la troisième étape de dépôt, est en outre imprimée, pour chaque pixel du dispositif, une région métallique EL1 définissant une électrode inférieure du photodétecteur du dispositif d'affichage.

Les éléments conducteurs imprimés lors de cette troisième étape de dépôt définissent le deuxième niveau conducteur M2 du substrat de report.

Après la troisième étape de dépôt, on vient former, pour chaque pixel, sur des zones conductrices du niveau métallique M2, dix plages métalliques P1, P2, P3, P4, P5, P6, P7, P8, P9 et P10 destinées à recevoir respectivement dix plages de connexion 131 distinctes de la puce élémentaire 153 du pixel. On vient en outre former, pour chaque pixel, sur des zones conductrices du niveau métallique M2, deux plages métalliques P11 et P12 destinées à recevoir respectivement deux plages de connexion distinctes de la diode VCSEL du pixel. Les plages P6, P7 et P8 sont connectées respectivement aux pistes conductrices L1, L2 et L3 du pixel. La plage P9 est connectée à l'électrode EL1 du pixel. Les plages P5 et P10 sont connectées respectivement aux plages P11 et P12 du pixel. Les connexions susmentionnées sont réalisées par des éléments conducteurs formés dans le niveau métallique M2, et, éventuellement, par des vias V (ouverts entre les deuxième et troisième étapes de dépôt) et des éléments conducteurs formés dans le niveau métallique M1.

Les figures 3A à 3C sont des vues en coupe illustrant des étapes successives d'un exemple d'un procédé de fabrication d'un dispositif d'affichage interactif selon un mode de réalisation.

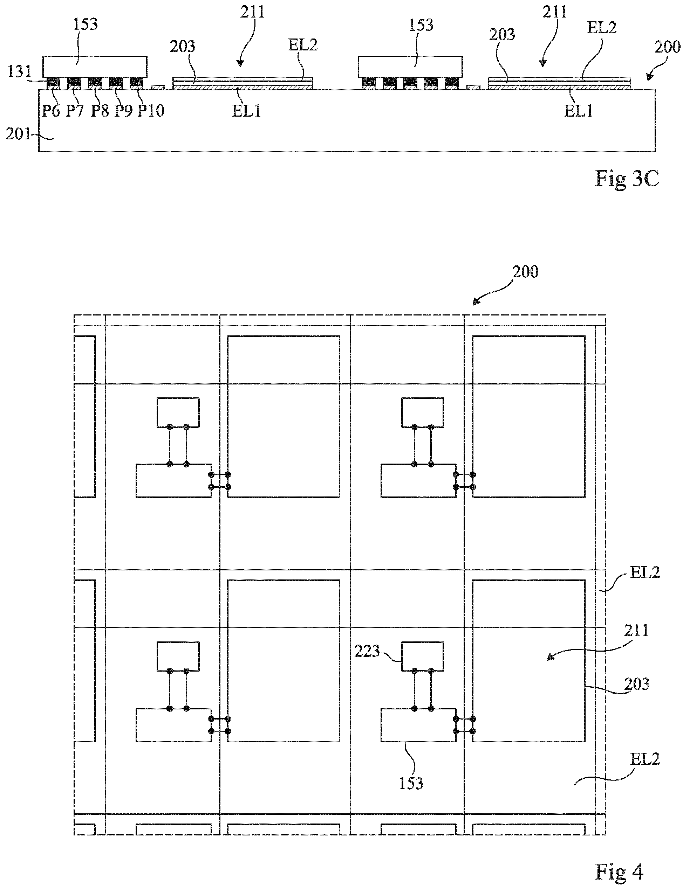

La figure 4 est une vue de dessus schématique du dispositif obtenu à l'issue du procédé des figures 3A à 3C.

Les figures 3A et 3B illustrent plus particulièrement une étape de transfert collectif de puces élémentaires de pixel 153 sur le substrat de report 200.

Les puces élémentaires 153 sont initialement fixées à une face du substrat de support temporaire 140. La structure comportant le substrat de support temporaire 140 et les puces élémentaires 153 est par exemple réalisée par un procédé du type décrit en relation avec les figures 1A à 1J. Dans l'exemple représenté, la structure est retournée par rapport à l'orientation de la figure 1J, c'est-à-dire que les puces élémentaires 153 sont disposées du côté de la face inférieure du substrat de support temporaire 140.

Par souci de simplification, sur les figures 3A à 3C, les puces élémentaires 153 et le substrat de report 200 ont été représentés de façon schématique, et de nombreux éléments ont été omis par rapport aux représentations des figures 1J et 2.

Les puces élémentaires 153 sont rapportées collectivement en vis-à-vis de la face de connexion du substrat de report 200, à savoir sa face supérieure dans l'orientation des figures 3A et 3B, en utilisant le substrat de support temporaire 140 comme poignée (figure 3A).

Les bornes de connexion 131 de puces élémentaires 153, situées du côté de la face inférieure desdites puces, sont alors mises en contact avec les plages de connexion correspondantes P1, P2, P3, P4, P5, P6, P7, P8, P9 et P10 du substrat de report 200, et fixées auxdites plages de connexion P1, P2, P3, P4, P5, P6, P7, P8, P9 et P10. La fixation des bornes de connexion 131 des puces élémentaires 153 aux plages de connexion du substrat de report est par exemple réalisée par collage direct, par thermocompression, par brasure, au moyen de microstructures métalliques (par exemple des micro-piliers) préalablement formées sur les bornes 131, ou par toute autre méthode de fixation et de connexion adaptée.

Une fois fixées, par leurs bornes de connexion 131, au substrat de report 200, les puces élémentaires 153 sont détachées du substrat de support temporaire 140 et ce dernier est retiré (figure 3B), libérant l'accès à la face d'émission des LED 123 (non détaillées sur les figures 3A à 3C).

Le pas des puces élémentaires 153 sur le substrat de report 200 peut être supérieur au pas des micropuces élémentaires 153 sur le substrat de support temporaire 140. De préférence, le pas des puces élémentaires 153 sur le substrat de report 200 est un multiple du pas des micropuces élémentaires 153 sur le substrat de support temporaire 140. Dans ce cas, seule une partie des puces 153 est prélevée sur le substrat de support 140 à chaque transfert, comme illustré sur les figures 3A et 3B. Les autres puces 153 restent solidaires du substrat de support temporaire 140 et peuvent être utilisées lors d'une autre étape de report collectif pour peupler une autre partie du substrat de report 200 ou un autre substrat de report.

Le procédé comprend en outre, avant ou après l'étape de report et de fixation des puces élémentaires 153 sur le substrat de report 200, une étape de report et de fixation, sur le même substrat de report 200, de puces élémentaires de diodes VCSEL 223 (figure 4 - non visibles sur les figures 3A à 3C), distinctes des puces élémentaires 153. Chaque puce élémentaire de diode VCSEL 223 comprend par exemple une unique diode VCSEL. Chaque puce élémentaire de diode VCSEL 223 comprend par exemple deux plages métalliques de connexion électrique disposées du côté de sa face tournée vers le substrat de report, appelée face de connexion, et destinées à être fixées et connectées électriquement aux plages de connexion métalliques P11 et P12 correspondantes du substrat de report 200. Chaque puce élémentaire de diode VCSEL 223 comprend par exemple uniquement deux plages métalliques de connexion au substrat de report 200, connectées respectivement à une région d'anode et à une région de cathode de la diode VCSEL.

Chaque puce élémentaire de diode VCSEL comprend une face d'émission lumineuse disposée du côté de la puce opposée à sa face de connexion. La face de connexion et la face d'émission sont par exemple parallèles à la face de connexion du substrat de report 200. A titre d'exemple, chaque diode VCSEL comprend une couche active émissive disposée entre deux structures réfléchissantes, par exemple des miroirs de Bragg. Les diodes VCSEL des puces 223 sont par exemple du type décrit dans l'article intitulé « Vertical-cavity surface-emitting lasers for optical interconnects » de Hui Li et al.

Les puces élémentaires de diode VCSEL 223 sont par exemple reportées et fixées sur le substrat de report 200 par un procédé de transfert collectif, par exemple similaire au procédé de transfert collectif des puces élémentaires de pixel 153 décrit en relation avec les figures 3A et 3B.

A titre de variante, les puces élémentaires de diode VCSEL 223 sont reportées et fixées sur le substrat de report 200 individuellement, par exemple par un procédé automatisé de prélèvement et placement (pick and place).

La figure 3C illustre le dispositif après fixation de l'ensemble des puces élémentaires 153 et des puces élémentaires de diode VCSEL 223 (non visibles sur la figure) sur le substrat de report 200.

La figure 3C illustre en outre une étape ultérieure de dépôt, dans chaque pixel, d'une portion de couche organique photosensible 203, par exemple sensible dans l'infrarouge ou dans le proche infrarouge, sur et en contact avec la face supérieure de l'électrode EL1 du pixel. Les portions de couche 203 sont par exemple déposées par un procédé d'impression localisée, par exemple par sérigraphie ou par un procédé de revêtement par filière à fente ("slot-die coating" en anglais). Dans chaque pixel, la portion de couche organique 203 s'étend par exemple sur toute la surface supérieure de l'électrode EL1 du pixel.

La figure 3C illustre de plus une étape ultérieure de dépôt, dans chaque pixel, d'une électrode supérieure EL2 sur et en contact avec la face supérieure de la portion de couche organique photosensible 203 du pixel. L'électrode EL2 s'étend par exemple sur toute la surface supérieure de la portion de couche organique photosensible 203 du pixel. L'électrode EL2 est transparente aux longueurs d'onde de sensibilité de la couche 203. A titre d'exemple, l'électrode EL2 est en un oxyde conducteur transparent, par exemple en ITO. Dans cet exemple, dans chaque pixel, l'empilement des couches EL1, 203 et EL2 forme un photodétecteur 211. Les électrodes EL1 et EL2 correspondent par exemple respectivement à l'électrode de cathode et à l'électrode d'anode du photodétecteur.

Les électrodes EL2 peuvent être déposées de façon localisée à travers un pochoir. A titre d'exemple, l'électrode supérieure EL2 est commune à tous les pixels du dispositif. L'électrode EL2 forme par exemple, en vue de dessus, une grille continue recouvrant les portions de couche photosensible 203 de tous les pixels du dispositif, par exemple tel qu'illustré sur la vue de dessus schématique de la figure 4. L'électrode commune EL2 peut alors être connectée à un noeud d'application d'un potentiel de polarisation fixe en périphérie de la matrice de pixels.

A titre de variante, les photodétecteurs 211 peuvent être formés avant les étapes de report et de fixation des puces élémentaires 153 et 223 sur le substrat de report 200, ou entre l'étape de report et de fixation des puces élémentaires 153 et l'étape de fixation des puces élémentaires 223 sur le substrat de report 200.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples particuliers de réalisation des puces élémentaires de pixel et du substrat de report décrits en relation avec les figures1A à 1J, 2, 3A à 3C et 4.

De plus, les modes de réalisation décrits ne se limitent pas au cas particulier décrit ci-dessus dans lequel les photodétecteurs du dispositif sont des photodiodes organiques. A titre de variante, les photodétecteurs organiques du dispositif décrit peuvent être remplacés par des photodétecteurs inorganiques, par exemple à base de matériaux semiconducteurs de type III-V, par exemple à base d'arséniure d'indium-gallium, ou à base de silicium amorphe. Dans une autre variante, les photodétecteurs 211 peuvent être constitués d'une couche matrice, par exemple en résine, dans laquelle sont incorporées des boîtes quantiques ("quantum dots" en anglais). A titre de variante, les photodétecteurs peuvent être des photodiodes en silicium en technologie CMOS, des photodiodes à avalanche, par exemple de type SPAD (de l'anglais « Single Photon Avalange Diode » - diode à avalanche à photon unique), ou tout autre dispositif de détection permettant de détecter un signal lumineux rétrodiffusé par la scène, par exemple permettant d'acquérir une information quant à la distance entre le dispositif et la scène observée, par exemple par mesure directe ou indirecte du temps de vol de la lumière.

Par ailleurs, les modes de réalisation décrits ne se limitent pas à l'exemple particulier décrit ci-dessus dans lequel le circuit électronique de lecture de chaque photodétecteur 211 est intégré à la puce élémentaire 153 du pixel correspondant. A titre de variante, le circuit électronique de lecture du photodétecteur peut être intégré dans une puce distincte. Dans ce cas, le photodétecteur 211 peut ne pas être connecté à la puce élémentaire 153 du pixel. A titre d'exemple, le photodétecteur 211 et le circuit électronique de lecture du photodétecteur 211 peuvent être intégrés dans une même puce monolithique distincte des puces 153 et 223, fixée et connectée électriquement à des plages de connexion électrique correspondantes du substrat de report 200. Dans une autre variante, chaque photodétecteur 211 peut être intégré à la puce élémentaire 153 du pixel correspondant.

Par ailleurs, les modes de réalisation décrits ne se limitent pas aux exemples particuliers décrits ci-dessus dans lesquels le dispositif comprend une puce élémentaire de diode VCSEL 223 et un photodétecteur 211 par puce élémentaire de pixel visible 153. A titre de variante, le nombre de puces élémentaires de diodes VCSEL 223 peut être inférieur au nombre de puces élémentaires 153. Dans ce cas, dans certaines puces élémentaires 153, le circuit de commande de la diode VCSEL n'est pas utilisé. De façon similaire, le nombre de photodétecteurs 211 peut être inférieur au nombre de puces élémentaires 153.

En outre, les modes de réalisation décrits ne se limitent pas aux exemples décrits ci-dessus d'application à des dispositifs d'affichage interactifs, mais peuvent s'appliquer plus généralement à d'autres dispositifs émissifs à LED pouvant tirer profit de l'utilisation de cellules émissives de type VCSEL, tout en restant dans le cadre de l'invention définie par les revendications attenantes.

Enfin, la mise en oeuvre pratique des modes de réalisation et variantes décrits est à la portée de la personne du métier à partir des indications fonctionnelles données ci-dessus.

## Revendications

1. Dispositif comportant :
- un substrat de report (200) comportant des éléments de connexion électrique ;
- une pluralité de premières puces élémentaires monolithiques (153) fixées et connectées électriquement au substrat de report (200), chaque première puce élémentaire (153) comportant au moins une LED (123) et un circuit électronique intégré de commande de ladite au moins une LED (123),
le dispositif comportant en outre, associé à au moins une des premières puces élémentaires (153), une deuxième puce élémentaire (223) comprenant une diode laser à cavité verticale émettant par la surface, fixée et connectée électriquement au substrat de report (200), la première puce élémentaire (153) comportant un circuit électronique intégré de commande de ladite diode laser.

2. Dispositif selon la revendication 1, comprenant en outre une pluralité de détecteurs photosensibles (211), et, associé à chaque détecteur photosensible, un circuit électronique intégré de lecture du détecteur photosensible connecté électriquement au substrat de report (200).

3. Dispositif selon la revendication 2, dans lequel chaque détecteur photosensible (211) est associé à une première puce élémentaire, le circuit électronique de lecture du détecteur photosensible (211) étant intégré à ladite première puce élémentaire.

4. Dispositif selon la revendication 2 ou 3, dans lequel chaque photodétecteur (211) comprend une couche organique photosensible.

5. Dispositif selon la revendication 2 ou 3, dans lequel chaque photodétecteur comprend une photodiode inorganique, par exemple à base de matériaux semiconducteurs de type III-V, par exemple à base d'arséniure d'indium-gallium, ou à base de silicium amorphe.

6. Dispositif selon la revendication 2 ou 3, dans lequel chaque photodétecteur comprend une couche matrice, par exemple en résine, dans laquelle sont incorporées des boîtes quantiques.

7. Dispositif selon la revendication 2 ou 3, dans lequel chaque photodétecteur comprend une photodiode en silicium en technologie CMOS, une photodiode à avalanche, ou un dispositif de détection permettant d'acquérir une information quant à la distance entre le dispositif et une scène observée par mesure directe ou indirecte du temps de vol de la lumière.

8. Dispositif selon l'une quelconque des revendications 2 à 7, dans lequel ladite diode laser est adaptée à émettre dans une gamme de longueurs d'ondes de sensibilité des photodétecteurs (211), par exemple dans l'infrarouge.

9. Dispositif selon l'une quelconque des revendications 1 à 8, dans lequel, dans chaque première puce élémentaire (153), le circuit électronique de commande de ladite au moins une LED et le circuit électronique de commande de la diode laser comprennent des transistors MOS formés dans et sur une couche (103c) de silicium monocristallin.

10. Dispositif selon l'une quelconque des revendications 1 à 9, dans lequel, dans chaque première puce élémentaire (153), ladite au moins une LED (123) est une LED inorganique, par exemple au nitrure de gallium.

11. Dispositif selon l'une quelconque des revendications 1 à 10, dans lequel, dans chaque première puce élémentaire (153), ladite au moins une LED (123) est adaptée à émettre de la lumière visible.

12. Dispositif selon l'une quelconque des revendications 1 à 11, dans lequel chaque première puce élémentaire (153) comporte un circuit électronique intégré adapté à commander une diode laser d'une deuxième puce élémentaire (223), et dans lequel le nombre de deuxièmes puces élémentaires (223) est inférieur au nombre de premières puces élémentaires (153), de sorte que certaines premières puces élémentaires (153) ont leur circuit de commande de diode laser non connecté à une diode laser.

13. Dispositif selon l'une quelconque des revendications 1 à 12, dans lequel ladite deuxième puce élémentaire (223) comprend deux plages métalliques de connexion reliées respectivement à une région d'anode et à une région de cathode de la diode laser, lesdites deux plages métalliques de connexion étant connectées à respectivement deux plages métalliques de connexion de la première puce élémentaire (153) par l'intermédiaire d'éléments conducteurs d'interconnexion du substrat de report (200).

## Patentansprüche

1. Vorrichtung, die Folgendes aufweist:
- ein Transfersubstrat (200), das elektrische Verbindungselemente aufweist,
- eine Vielzahl von ersten monolithischen Elementarchips (153), die gebondet und elektrisch verbunden mit dem Transfersubstrat (200) sind, wobei jeder erste Elementarchip (153) wenigstens eine LED (123) und eine integrierte elektronische Schaltung zum Steuern der wenigstens einen LED (123) aufweist,
die Vorrichtung ferner aufweisend, assoziiert mit wenigstens einem der ersten Elementarchips (153), einen zweiten Elementarchip (223), der eine oberflächenemittierende Laserdiode mit vertikalem Hohlraum aufweist, gebondet und elektrisch verbunden mit dem Transfersubstrat (200), wobei der erste Elementarchip (153) eine integrierte elektronische Schaltung zum Steuern der Laserdiode aufweist.

2. Vorrichtung nach Anspruch 1, ferner aufweisend eine Vielzahl von photosensitiven Detektoren (211) und, assoziiert mit jedem photosensitiven Detektor, eine integrierte elektronische Schaltung zum Auslesen des photosensitiven Detektors, die elektrisch mit dem Transfersubstrat (200) verbunden ist

3. Vorrichtung nach Anspruch 2, wobei jeder photosensitive Detektor (211) mit einem ersten Elementarchip assoziiert ist, wobei die elektronische Schaltung zum Lesen des photosensitiven Detektors (211) in den ersten Elementarchip integriert ist.

4. Vorrichtung nach Anspruch 2 oder 3, wobei jeder Photodetektor (211) eine organische photosensitive Schicht aufweist.

5. Vorrichtung nach Anspruch 2 oder 3, wobei jeder Photodetektor eine anorganische Photodiode aufweist, beispielsweise basierend auf Typ-III-V-Halbleitermaterialien, beispielsweise basierend auf Indium-Gallium-Arsenid, oder basierend auf amorphem Silizium.

6. Vorrichtung nach Anspruch 2 oder 3, wobei jeder Photodetektor eine Matrixschicht aufweist, die beispielsweise aus Harz gefertigt ist und in die Quantenpunkte eingearbeitet sind.

7. Vorrichtung nach Anspruch 2 oder 3, wobei jeder Photodetektor eine Photodiode, die aus Silizium in CMOS-Technologie hergestellt ist, eine Avalanche-Photodiode oder eine Detektionsvorrichtung aufweist, die es ermöglicht, Informationen zu erfassen, und zwar in Bezug auf den Abstand zwischen der Vorrichtung und einer Szene, die durch direkte oder indirekte Messung der Lichtlaufzeit beobachtet wird.

8. Vorrichtung nach einem der Ansprüche 2 bis 7, wobei die Laserdiode eingerichtet ist zum Emittieren in einem Wellenlängenbereich der Empfindlichkeit der Photodetektoren (211), zum Beispiel im Infrarotbereich.

9. Vorrichtung nach einem der Ansprüche 1 bis 8, wobei in jedem ersten Elementarchip (153) die elektronische Schaltung zum Steuern der wenigstens einen LED und die elektronische Schaltung zum Steuern der Laserdiode MOS-Transistoren aufweisen, die innerhalb und auf einer einkristallinen Siliziumschicht (103c) ausgebildet sind.

10. Vorrichtung nach einem der Ansprüche 1 bis 9, wobei in jedem ersten Elementarchip (153) die wenigstens eine LED (123) eine anorganische LED ist, beispielsweise mit Galliumnitrid.

11. Vorrichtung nach einem der Ansprüche 1 bis 10, wobei in jedem ersten Elementarchip (153) die wenigstens eine LED (123) eingerichtet ist, um sichtbares Licht zu emittieren.

12. Vorrichtung nach einem der Ansprüche 1 bis 11, wobei jeder erste Elementarchip (153) eine integrierte elektronische Schaltung aufweist, die eingerichtet ist zum Steuern einer Laserdiode eines zweiten Elementarchips (223), und wobei die Anzahl der zweiten Elementarchips (223) kleiner ist als die Anzahl der ersten Elementarchips (153), so dass bestimmte erste Elementarchips (153) ihre Laserdiodensteuerschaltung nicht mit einer Laserdiode verbunden haben.

13. Vorrichtung nach einem der Ansprüche 1 bis 12, wobei der zweite Elementarchip (223) zwei Metallverbindungsgebiete aufweist, die jeweils mit einem Anodenbereich und mit einem Kathodenbereich der Laserdiode gekoppelt sind, wobei die beiden Metallverbindungsgebiete mit jeweils zwei Metallverbindungsgebieten des ersten Elementarchips (153) verbunden sind, und zwar über leitende Verbindungselemente des Transfersubstrats (200).

## Claims

1. Device comprising:
- a transfer substrate (200) comprising electric connection elements;
- a plurality of first elementary monolithic chips (153) bonded and electrically connected to the transfer substrate (200), each first elementary chip (153) comprising at least one LED (123) and one integrated electronic circuit for controlling said at least one LED (123),
the device further comprising, associated with at least one of the first elementary chips (153), a second elementary chip (223) comprising a vertical cavity surface-emitting laser diode, bonded and electrically connected to the transfer substrate (200), the first elementary chip (153) comprising an integrated electronic circuit for controlling said laser diode.

2. Device according to claim 1, further comprising a plurality of photosensitive detectors (211), and, associated with each photosensitive detector, an integrated electronic circuit for reading from the photosensitive detector electrically connected to the transfer substrate (200).

3. Device according to claim 2, wherein each photosensitive detector (211) is associated with a first elementary chip, the electronic circuit for reading from the photosensitive detector (211) being integrated to said first elementary chip.

4. Device according to claim 2 or 3, wherein each photodetector (211) comprises an organic photosensitive layer.

5. Device according to claim 2 or 3, wherein each photodetector comprises an inorganic photodiode, for example based on type-III-V semiconductor materials, for example based on indium gallium arsenide, or based on amorphous silicon.

6. Device according to claim 2 or 3, wherein each photodetector comprises a matrix layer, for example made of resin, having quantum dots incorporated therein.

7. Device according to claim 2 or 3, wherein each photodetector comprises a photodiode made of silicon in CMOS technology, an avalanche photodiode, or a detection device enabling to acquire information relative to the distance between the device and an observed scene by direct or indirect measurement of the time of flight of light.

8. Device according to any of claims 2 to 7, wherein said laser diode is adapted to emitting in a wavelengths range of responsivity of the photodetectors (211), for example in infrared.

9. Device according to any of claims 1 to 8, wherein, in each first elementary chip (153), the electronic circuit for controlling said at least one LED and the electronic circuit for controlling the laser diode comprise MOS transistors formed inside and on top of a single-crystal silicon layer (103c).

10. Device according to any of claims 1 to 9, wherein, in each first elementary chip (153), said at least one LED (123) is an inorganic LED, for example with gallium nitride.

11. Device according to any of claims 1 to 10, wherein, in each first elementary chip (153), said at least one LED (123) is adapted to emitting visible light.

12. Device according to any of claims 1 to 11, wherein each first elementary chip (153) comprises an integrated electronic circuit adapted to controlling a laser diode of a second elementary chip (223), and wherein the number of second elementary chips (223) is smaller than the number of first elementary chips (153), so that certain first elementary chips (153) have their laser diode control circuit not connected to a laser diode.

13. Device according to any of claims 1 to 12, wherein said second elementary chip (223) comprises two metal connection areas respectively coupled to an anode region and to a cathode region of the laser diode, said two metal connection areas being connected to respectively two metal connection areas of the first elementary chip (153) via conductive interconnection elements of the transfer substrate (200).
